# EUROPEAN PATENT SPECIFICATION

(11) **EP 1 866 974 B1**
(45) Date of publication and mention of the grant of the patent: **10.01.2018**
(21) Application number: 06725454.0
(22) Date of filing: 31.03.2006
(51) Int. Cl.: H01L 31/18, H01L 31/0224, H01L 31/0392

(54) **PROCESS FOR MANUFACTURING PIECES OF A FOIL HAVING AN INORGANIC COATING OF E. G. TCO**
VERFAHREN ZUR HERSTELLUNG VON FOLIENTEILEN MIT ANORGANISCHER BESCHICHTUNG, Z.B. AUS TCO
PROCÉDÉ DE FABRICATION DE PIÈCES D'UNE FEUILLE PRÉSENTANT UN REVÊTEMENT INORGANIQUE DE TCO

(30) Priority: 06.04.2005 EP 05075792; 02.05.2005 US 676286 P
(43) Date of publication of application: 19.12.2007
(73) Proprietor: HyET Energy Systems B.V., 6827 AV Arnhem (NL)
(72) Inventor: DE JONGE, Ludmila, V., 6987 AG Giesbeek (NL)
(74) Representative: Hesselink, Dinah Elisabeth
(86) International application number: PCT/EP2006/061206
(87) International publication number: WO 2006/106072

(56) References cited:
- WO-A-2005/015638
- US-A- 5 385 848
- US-A1- 2002 031 863
- YASUO KISHI: "A LASER WELDING AND SCRIBING (LWS) METHOD FOR A HIGH-YIELD INTEGRATED-TYPE A-SI SOLAR CELL" JAPANESE JOURNAL OF APPLIED PHYSICS, JAPAN SOCIETY OF APPLIED PHYSICS, TOKYO, JP, vol. 30, no. 8, 1 August 1991 (1991-08-01), pages 1628-1634, XP000265577 ISSN: 0021-4922

## Description

The invention pertains to a process for manufacturing pieces of a foil having an inorganic coating, and to pieces of foil thus obtained.

Foils having an inorganic coating are known in the art. For example solar cell units, also known as photovoltaic units or photovoltaic foils, generally comprise a carrier and a photovoltaic (PV) layer composed of a semiconductor material provided between a front electrode comprising an inorganic material, more particularly a transparent conductive oxide (TCO) (at the front of the foil) and a back electrode (at the back of the foil). The front electrode is transparent, enabling incident light to reach the semiconductor material, where the incident radiation is converted into electric energy. In this way light can be used to generate electric current, which offers an interesting alternative to, say, fossil fuels or nuclear power.
Other foils comprising inorganic materials are OLEDs, optical layers such as reflective or anti-reflective layers, and displays.

WO 98/13882 and WO99/49483 describe methods for manufacturing a photovoltaic foil comprising the steps of providing a temporary substrate, applying the transparent conductive oxide, applying the photovoltaic layers, applying the back electrode layer, applying the carrier, removing the temporary substrate, and, preferably, applying a transparent protective top coat on the side of the transparent conductor layer. This method enables the roll-to-roll manufacture of a photovoltaic foil or device, while at the same time making it possible to use any desired transparent conductor material and deposition process, without jeopardizing the current-generating action of the PV layers. WO 01/78156 and WO 01/47020 describe variations on this process. Other foils with inorganic materials can be made according to a similar process.
In the case of photovoltaic cells it is preferred to use a metallic temporary substrate because such materials generally will be able to withstand the highest temperatures during further processing, suffer little from evaporation, and can be removed relatively easily using known etching techniques. Another reason to choose metal, notably aluminum or copper, is that the PV foil should eventually contain "side" electrodes (which form a contact for connection to any auxiliary apparatus or net, i.e., to actually use the PV foil as a source of power). By allowing part of the temporary substrate to remain in place (e.g., as side edges or stripes) these contacts do not need to be applied separately.

In order to improve the collection of current from the solar cell unit, solar cell units frequently are provided with a current collection grid. In the case of solar cell foil units the grid is applied on the front electrode and/or, less commonly, on the back electrode if the back electrode is made of a comparatively poorly conductive TCO to obtain a (semi)transparent solar cell unit. The grid is a pattern of lines of a conductive material which is applied in such a way as to enable easy collection of the current generated in the photovoltaic layer and flowing through the electrode.

Various ways of applying grids are known in the art. It is known, for example, to apply a grid via a printing technique, generally using a paste containing silver particles. The disadvantage of using this type of paste is that its conductivity is relatively low. It is possible to increase the conductivity by firing the paste, but this introduces an additional processing step. Also, the firing generally has a detrimental effect on the properties of the solar cell unit, in particular on those of the photovoltaic layer and optional polymer layers, while the resulting conductivity of the grid still leaves something to be desired.
It is also known in the art to apply the grid by depositing molten metal. Although this results in a grid with a good conductivity, the high temperature of the molten metal usually detrimentally affects the properties of the TCO layer, in particular of the photovoltaic layer. Also, a number of additional steps are required to prepare the surface for metals deposition.

Recent developments concern the deposition at relatively low temperatures of metallic layers that can solidify spontaneously after their application. At present, however, these methods do not yield photovoltaic devices of acceptable quality. WO 93/00711 describes the formation of a current collection grid on top of the layer of transparent conductive material by securing an electrically conductive foil thereto by way of an electrically conductive adhesive. Subsequently, a portion of the conductive foil is removed via an etching technique. One problem associated with this process resides in the conductive adhesive, which should also be removed in the locations where the conductive foil has been removed. This may, e.g., be done by way of a solvent, but this incurs the risk that the solvent will also dissolve the adhesive bonding the current collection grid to the front electrode. A further problem associated with this process is the conductivity of the connection between the current collection grid and the TCO layer via the adhesive.

These solar cells, and correspondingly other layers comprising inorganic materials are manufactured in continuous sheets. Before use these sheets are cut into suitable pieces of required size. Cutting can be performed by succors, knives, cutters, and the like. The inorganic layer, such as the TCO layer, however, is a relatively brittle layer. Cutting, excising, etc, therefore almost invariably lead to cracks in such layer around the cutting sites. If large pieces of foil are made, such cracks may sometimes be acceptable, but when small pieces are made the cracked area is relatively large and therefore unacceptable. There is therefore need for a process for manufacturing pieces of a foil having an inorganic coating provides such pieces wherein the amount of cracking is significantly reduced or even fully prevented.

It has now been found that these problems can be solved by manufacturing the pieces of a foil having an inorganic coating by a process according to claim 1.

Thus the invention, inter alia, provides a method wherein at least part of the temporary substrate is maintained at the position of the cutting lines. It was found that that if the width of such temporary substrate has a width of at least 0.25 mm to the cutting line, sufficient support is provided to the inorganic layer so to prevent cracking thereof during the cutting process.

Because it may be more difficult to cut the foil through the temporary substrate, for example and preferably an aluminum layer, than through the polymeric permanent support and inorganic layer only, a further improvement was found in providing a cutting line without temporary support. To this end, the temporary substrate is first removed, for example by etching, at the cutting line, and possibly as less as possible outside the cutting line. Thus in this manner the cutting line is free from temporary substrate, thus easily cuttable, whereas at least 0.25 mm left and right from the cutting line still temporary substrate is present to provide support to the foil and to prevent cracking of the inorganic layer.

It is clear that the more the temporary substrate extends left and right from the cutting line, the more support is offered to the inorganic layer. For that reason it is preferred to use "strips" of temporary substrate that follow the cutting line. Such strips preferably have a width less than 20 cm, preferably less than 10 cm, more preferably less than 3 cm. The minimum width of such strips is at least 0.5 mm. If the cutting line is positioned in the middle of the strip, a piece of a foil is obtained comprising a strip of temporary substrate having a width between 20 cm and 0.5 mm at the edge of the side(s) that is (are) cut from the foil. Such cut foil pieces also comprise an object of the invention. These strips may also function as electric circuitry, for instance when making printed wiring boards, or as safety means for electric grounding. These strips when applied to the edges of the foil and the final product protect against damage of the inorganic layer.

In the context of the present specification, the term etching is intended to mean removing by chemical means, e.g., dissolution. An etchable substrate is a substrate which can be removed by chemical means; an etch-resist is a material which can resist the conditions applied during the removal of the temporary substrate.

The temporary substrate is preferably a metallic substrate that is conductive and can act as a back electrode. If parts of the temporary substrate are removed, this is commonly performed by local etching or/and globally etching part of the temporary substrate. Additionally, taking into account that the use of a temporary substrate always necessitates its partial or whole removal, generally by way of an etching step, the process according to the invention provides a special manner of performing such removal, leading to foils that can easily be cut without introducing cracks in the inorganic layer, such as the TCO layer.

To prevent etching on the parts that are used as the strips at the cutting line positions an etch-resistant may be used. The etch-resist can be any material which can be applied to the temporary substrate in the form of the current collection grid and which will protect the temporary substrate from the action of the etchant. The etch-resist may be temporary, that is, it may be removed at some further stage of the process. Alternatively, the etch-resist may be permanent. The use of a permanent etch-resist is preferred. There are various reasons for this preference. In the first place, the use of a permanent etch-resist obviates the need for an etch-resist removal step. Further, the etch-resist will protect the foil from outside influences and add to the dielectric breakdown strength of the encapsulated module.

The application of the etch-resist onto the temporary substrate can be carried out at any stage in the process according to the invention. It can, e.g., be applied before the beginning of the process, that is, before the application of the TCO onto the other side of the temporary substrate. It can be applied at any intermediate stage, and it can be applied at the end of the process, that is, after the application of the back electrode or, where applicable, the permanent carrier, and just before removal of the temporary substrate by etching. The latter option is preferred, because it prevents the etch-resist pattern being damaged during the preceding parts of the process. It also prevents the presence of the etch-resist pattern on the "back" of the temporary substrate from interfering with the other processing steps. In the preferred roll-to-roll embodiment of the process according to the invention both may happen if the temporary substrate provided with a pattern in an etch-resist on the back is led over one or more rolls.

In a preferred embodiment of the process according to the invention, the temporary substrate is flexible, a flexible permanent carrier is applied, and the process is carried out by way of a roll-to-roll process.

The process is further illustrated by the figures.
Fig. 1 shows the foil cut through a remained strip of the temporary substrate
Fig. 2 shows the foil cut through a cutting line in between two remained strips of the temporary substrate.

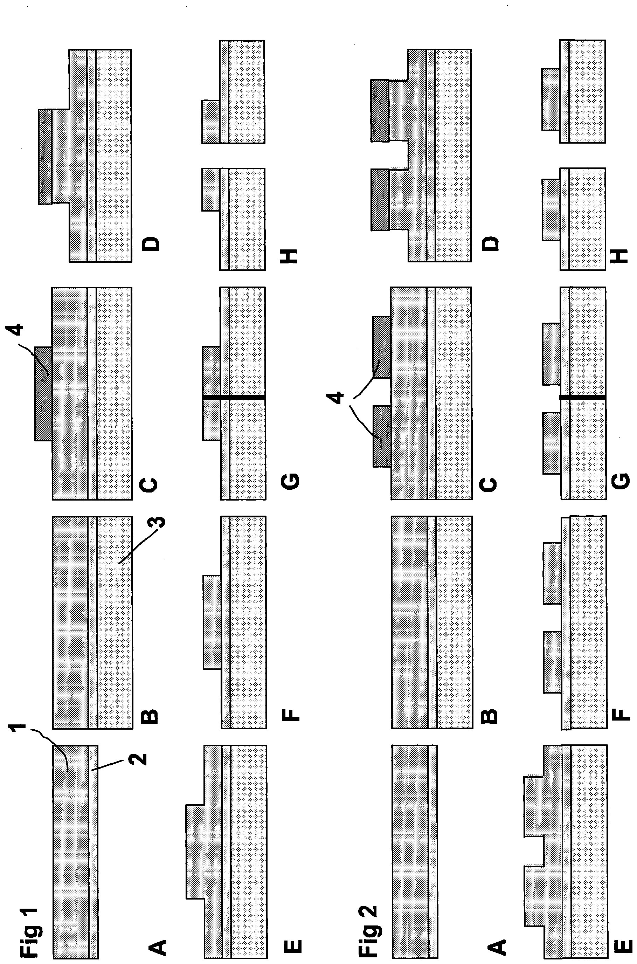

In Fig. 1A a TCO layer 2 (the inorganic layer) is applied to the aluminum superstrate (the temporary substrate) 1. In Fig. 1B the permanent substrate 3 is laminated to the TCO layer. In Fig. 1C an etch-resistant 4 is applied to the aluminum layer. In Fig. 1D the aluminum layer is partly etched (which is an optional step). In Fig. 1E the etch resistant is removed. In Fig.1F the aluminum substrate is further etched down to the inorganic layer leaving part of it. In Fig 1G the foil is cut at the position of the left aluminum superstrate. The result is two parts without damage of the brittle inorganic layer (Fig. 1H).

In Fig. 2 2A-2B and 2D-2G are similar to Fig. 1A-1B and 1D-1G, respectively. In Fig. 2C two parallel strips of etch resistant 4 are applied to the aluminum layer so that after pre-etching and final etching two strips of aluminum are left. The foil is cut in between the two strips. Eventually occurring cracks in the brittle inorganic layer next to the cut are stopped by the aluminum strips (Fig. 2H).
Of course the pattern that is formed by the remaining aluminum can have any shape. The inorganic layer may be a stack of several layers. The layers can form a "photo-voltaic layer" which term is explained further on.

### The temporary substrate

The temporary substrate has to satisfy a number of conditions. It has to be sufficiently conductive to be able to serve as a base material for a current collection grid. It has to be sufficiently heat-resistant to be able to endure the conditions prevailing during the manufacture of the foil, more particularly during the deposition of the inorganic layer, such as the TCO layer, and the PV layer. It has to be strong enough to be able to carry the foil unit during its manufacture. It has to be easy to remove from the inorganic layer without damaging the latter. The person skilled in the art will be able to select a suitable temporary substrate within these guidelines.

The temporary substrate employed in the process according to the invention preferably is a foil of a metal or a metal alloy. The principal reasons for this are that such foils exhibit good conductivity, generally are able to withstand high processing temperatures, are slow to evaporate, and are comparatively easy to remove using known etching techniques. Another reason to choose a metal foil, more particularly aluminum or copper, is that in the end the foil has to be provided with edge electrodes which have to connect the unit to an apparatus or the electricity grid. Remaining pieces of temporary substrate may be used to this end, as a result of which there is no need for separate provision of the edge electrodes.

Suitable metals include steel, aluminum, copper, iron, nickel, silver, zinc, molybdenum, chromium, and alloys or multi-layers thereof. For economic reasons among others it is preferred to employ Fe, Al, Cu, or alloys thereof. Given their performance (and taking into account the matter of cost) iron and copper are preferred, and most preferred is aluminum.

Suitable etchants and techniques for removing metals are known, and while they differ per metal, the skilled person will be able to select the appropriate ones. Preferred etchants include acids (both Lewis and Brønstedt acids). Thus in the case of copper it is preferred to use FeCl₃, nitric acid or sulphuric acid. Suitable etchants for aluminium are, e.g., NaOH, KOH, and mixtures of phosphoric acid and nitric acid.

If copper, optionally prepared by way of electrodeposition, is used as temporary substrate, it is preferred to provide the copper, optionally via electrodeposition, with a non-reducing diffusion barrier layer, e.g., an anti-corrosion layer, more particularly zinc oxide. This is because copper may have the tendency to diffuse through the TCO layer in the PV layer. It is also possible to select a TCO capable of preventing such diffusion, e.g., SnO₂ or ZnO. The anti-diffusion layers can be applied by means of for instance electrodeposition, or via Physical Vapor Deposition (PVD) or via Chemical Vapor Deposition (CVD).

For ease of removal, the temporary substrate preferably is as thin as possible. On the other hand, a certain thickness is required to ensure that the strips obtained from the temporary substrate provide sufficient support, and if necessary, for instance as an electrode, sufficient current. Further, its thickness has to be such that other layers can be provided on it and it has to be able to hold these together, but this generally does not require it to be more than 500 µm (0.5 mm) thick. The thickness preferably is in the range of 1 to 200 µm (0.2 mm). Depending on the modulus of elasticity, the minimum thickness for a large number of materials will be 5 µm. Accordingly, a thickness of 5-150 µm, more particularly 10-100 µm, is preferred.

Incidentally, by proper selection of the width of the etch-resist in combination with the thickness of the temporary substrate, the current crack-preventing properties can be regulated. By varying the width of the etch-resist over the surface of the foil, the properties can be adapted.

### The inorganic layer

Examples of suitable inorganic layers are metal oxides, ceramics, glass, and the like, and particularly transparent conductive oxides (TCOs) including indium tin oxide, zinc oxide, zinc oxide doped with aluminum, fluorine, gallium or boron, cadmium sulfide, cadmium oxide, tin oxide, and, most preferably, F-doped SnO₂. Said last-mentioned transparent electrode material is preferred, because it can form a desired crystalline surface with a columnar light scattering texture when it is applied at a temperature above 400° C, preferably in the range of 500 to 600° C, or after-treated at said temperature. It is precisely in the case of this TCO material that the use of a temporary substrate capable of withstanding such a high temperature is extremely attractive. In addition, the material is resistant to most etchants and has a better resistance to chemicals than the much-used indium tin oxide. Also, it is far less costly.

The TCO can be applied by means of methods known in the field, e.g., by means of Metal Organic Chemical Vapor Deposition (MOCVD), sputtering, Atmospheric Pressure Chemical Vapor Deposition (APCVD), PECVD, spray pyrolysis, evaporation (physical vapor deposition), electrodeposition, electroless plating, screen printing, sol-gel processes, etc. or combinations of these processes. It is preferred to apply and after-treat the TCO layer at a temperature above 250° C, preferably above 400° C, more preferably between 450 and 600° C, so that a TCO layer of the desired composition, properties and/or texture can be obtained.

### The buffer layer

If so desired, a buffer layer may be present between the inorganic layer and the photovoltaic layer. The buffer layer is intended to protect the inorganic layer from the conditions prevailing during the deposition of other layers, such as the PV layer. The nature of the buffer layer will depend on the nature of said other layer. Suitable buffer layers for the various layers are known in the art. For cadmium telluride CdS, In(OH,S) and Zn(OH,S) may be mentioned. If in the present specification mention is made of depositing a PV layer on a TCO, a buffer layer may or may not be present on said TCO.

### The photovoltaic (PV) layer

After application of the TCO layer a PV layer may be applied in an appropriate manner. It should be noted here that in the present description the term "PV layer" or "photovoltaic layer" comprises the entire system of layers needed to absorb the light and convert it into electricity. Suitable layer configurations are known, as are the methods for applying them. For the common general knowledge in this field reference may be had to Yukinoro Kuwano, "Photovoltaic Cells," Ullmann's Encyclopedia, Vol.A20 (1992), 161 and "Solar Technology," Ullmann's Encyclopedia, Vol.A24 (1993), 369.

Various thin film semiconductor materials can be used in manufacturing the PV layers. Examples are amorphous silicon (a-Si:H), microcrystalline silicon, polycrystalline amorphous silicon carbide (a-SiC) and a-SiC:H, amorphous silicon-germanium (a-SiGe), and a-SiGe:H. In addition, the PV layer in the solar cell unit according to the invention may comprise CIS (copper indium diselenide, CuInSe₂), cadmium telluride (CdTe), CIGSS (Cu(In,Ga)(Se,S)), Cu(In,Ga)Se₂, ZnSe/CIS, ZnO/CIS, and/or Mo/CIS/CdS/ZnO, and dye sensitised solar cells.

The PV layer preferably is an amorphous silicon layer when the TCO comprises a fluorine-doped tin oxide. In that case the PV layer will generally comprise a set, or a plurality of sets, of p-doped, intrinsic, and n-doped amorphous silicon layers, with the p-doped layers being situated on the side receiving the incident light.
In the a-Si-H embodiment the PV layer will at least comprise a p-doped amorphous silicon layer (Si-p), an intrinsic amorphous silicon layer (Si-i), and an n-doped amorphous silicon layer (Si-n). It may be that onto the first set of p-i-n layers a second and further p-i-n layers are applied. Also, a plurality of repetitive p-i-n ("pinpinpin" or "pinpinpinpin") layers can be applied consecutively. By stacking a plurality of p-i-n layers, the voltage per cell is raised and the stability of the system is enhanced. Light-induced degradation, the so-called Staebler-Wronski effect, is diminished. Furthermore, the spectral response can be optimized by choosing different band-gap materials in the various layers, mainly the i-layers, and particularly within the i-layers. The overall thickness of the PV layer, more particularly of all the a-Si layers together, will generally be of the order of 100 to 2,000 nm, more typically about 200 to 600 nm, and preferably about 300 to 500 nm.

### The back electrode

The back electrode in the thin film solar cell sheet according to the invention preferably serves both as reflector and as electrode, but may also serve as a support for the inorganic layer to prevent cracks during cutting. Generally, the back electrode will have a thickness of about 50 to 500 nm, and it may comprise any suitable material having light reflecting properties, preferably aluminum, silver, or a combination of layers of both, and making good ohmic contact with the subjacent semiconductor layer. Preferably, it is possible to apply the metal layers at a comparatively low temperature, say less than 250° C, by means of, e.g., electrodeposition, (*in vacuo*) physical vapor deposition or sputtering. In the case of silver, it is preferred to first apply an adhesion promoter layer. TiO₂, TiN, ZnO, and chromium oxide are examples of suitable materials for an adhesion promoter layer and have the advantage of also possessing reflecting properties when applied in a suitable thickness, e.g., of 50-100 nm. The required back electrode may be either transparent or opaque.

### The permanent carrier

Although it is not essential to the process according to the invention, as a rule it is preferred to provide the foil with a permanent carrier. For, otherwise the foil will be so thin that its fragility makes for difficult handling. When employed, the permanent carrier is applied on the back electrode. Suitable carrier layer materials include films of commercially available polymers, such as polyethylene terephthalate, poly(ethylene 2,6-naphthalene dicarboxylate), polycarbonate, polyvinyl chloride, PVDF, PVDC, PPS, PES, PEEK, PEI or films of polymer having very good properties such as aramid, polyamide, or polyimide films, but also, for example, metal foils onto which an insulating (dielectric) surface layer may have been applied, or compositions of plastics and reinforcing fibers and fillers. Polymeric "co-extruded" films provided with a thermoplastic adhesive layer having a softening point below that of the substrate itself are preferred. If so desired, the co-extruded film may be provided with an anti-diffusion layer of, e.g., polyester (PET), copolyester or aluminum. The thickness of the carrier preferably is 50 µm to 10 mm. Preferred ranges are 75 µm to 3 mm and 100 µm to 300 µm. The bending stiffness of the carrier, defined within the context of this description as the product of the modulus of elasticity E in N/mm² and the thickness t to the power of three in mm (E x t³), preferably is higher than 16x10⁻² Nmm and will generally be lower than 15x10⁶ Nmm.

The carrier may comprise a structure as required for its final use. Thus the substrate may comprise tiles, roofing sheets and elements, facade elements, car and caravan roofs, etc. In general, however, preference is given to the carrier being flexible. In that case a roll of solar cell foil is obtained which is ready for use and where sheets of the desired power and voltage can be cut off the roll. These can then be incorporated into (hybrid) roof elements or be applied onto tiles, roofing sheets, car and caravan roofs, etc., as desired.

If so desired, a top coat or surface layer may be provided on the inorganic side of the foil to protect the inorganic from outside influences. Generally, the surface layer will be a polymer sheet (with cavities if so desired) or a polymer film. The surface layer is required to have a high transmission and for instance comprises the following materials: (per)fluorinated polymers, polycarbonate, poly(methylmethacrylate), PET, PEN or any clear coating available, such as the ones used in the car industry. If so desired, an additional anti-reflection or anti-fouling layer may be provided. Alternatively, if so desired, the entire solar cell may be incorporated into such an encapsulant.

### The etch-resist

The etch-resist can be any material which can be applied to the temporary substrate in the form of the current collection grid and which will protect the temporary substrate from the action of the etchant. The skilled person can select suitable material by routine testing. Suitable etch-resists include thermoplastic and thermoset polyurethanes and polyimides, thermoset polymers such as EP, UP, VE, SI, (epoxy)resins, and acrylates, and thermoplastic polymers such as PVC, PI, fluorpolymers, etc. The etch-resist generally includes additives such as photoinitiators or other hardeners, fillers, plastifiers, etc. The etch-resist may be temporary, that is, it may be removed at some further stage of the process. Alternatively, and preferably, the etch-resist may be permanent.
The etch-resist is suitably applied by vaporizing or printing/writing. Preferably, the etch-resist is applied by means of a printing process known as such. Suitable printing processes include silk screening, roto screen printing, ink-jet processes, flexgravure, direct extrusion, etc. The color of the etch-resist can be regulated by the incorporation of suitable pigments or dyes known to the skilled person. Especially for permanent etch-resists, the presence of pigments and UV stabilizers may be preferred.

## Claims

1. A process for manufacturing pieces of a foil having an inorganic coating, the process comprising the successive steps of:
(a) providing an etchable temporary substrate foil,
(b) applying the inorganic coating onto the temporary substrate foil,
(c) applying a permanent carrier,
(d) removing part of the temporary substrate foil,
(e) cutting the foil along a cutting line into the pieces, wherein the cutting line is positioned at a portion of the foil where the temporary substrate foil is present, said portion having a width of at least 0.25 mm relative to each side of the cutting line,
(f) removing at least part of the temporary substrate foil.

2. The process according to claim 1 wherein between step (c) and step (e) the temporary substrate foil at the position of the cutting line is removed by etching.

3. The process according to claim 1 or 2 wherein the temporary substrate foil has a width of at least 1 mm relative to each side of the cutting line.

4. The process according to any one of claims 1 to 3 wherein the cutting line is positioned on a strip of the temporary substrate foil, the strip having a width less than 20 cm, preferably less than 10 cm, more preferably less than 3 cm.

5. The process according to any one of claims 1 to 4 wherein the foil having an inorganic coating is a solar cell, an organic lighting device, or a display, the process comprising the steps of:
(b) applying a front electrode of a transparent conductive oxide (TCO) onto the temporary substrate foil,
(b1) applying a photovoltaic layer, an OLED layer, or a front panel laminate layer onto the TCO layer,
(b2) applying a back electrode layer.

6. The process according to any one of claims 1 to 5 wherein the temporary substrate foil is aluminum.

## Patentansprüche

1. Verfahren zur Herstellung von Stücken einer Folie mit einer anorganischen Beschichtung, wobei das Verfahren die aufeinanderfolgenden Schritte aufweist:
(a) Bereitstellen einer ätzbaren temporären Substratfolie,
(b) Auftragen der anorganischen Beschichtung auf die temporäre Substratfolie,
(c) Auftragen eines permanenten Trägers,
(d) Entfernen eines Teils der temporären Substratfolie,
(e) Schneiden der Folie entlang einer Schnittlinie in die Stücke, wobei die Schnittlinie an einem Abschnitt der Folie positioniert ist, an dem die temporäre Substratfolie vorhanden ist, wobei der Abschnitt eine Breite von mindestens 0,25 mm relativ zu jeder Seite der Schnittlinie hat,
(f) Entfernen mindestens eines Teils der temporären Substratfolie.

2. Verfahren nach Anspruch 1, wobei zwischen dem Schritt (c) und dem Schritt (e) die temporäre Substratfolie an der Position der Schnittlinie durch Ätzen entfernt wird.

3. Verfahren nach Anspruch 1 oder 2, wobei die temporäre Substratfolie eine Breite von mindestens 1 mm relativ zu jeder Seite der Schnittlinie hat.

4. Verfahren nach einem der Ansprüche 1 bis 3, wobei die Schnittlinie auf einem Streifen der temporären Substratfolie positioniert ist, wobei der Streifen eine Breite unter 20 cm, vorzugsweise unter 10 cm, stärker bevorzugt unter 3 cm hat.

5. Verfahren nach einem der Ansprüche 1 bis 4, wobei die Folie mit einer anorganischen Beschichtung eine Solarzelle, eine organische Beleuchtungsvorrichtung oder ein Display ist, wobei das Verfahren die Schritte aufweist:
(b) Auftragen einer Frontelektrode aus einem transparenten leitenden Oxid (TCO) auf die temporäre Substratfolie,
(b1) Auftragen einer Photovoltaikschicht, einer OLED-Schicht oder einer Frontplatten-Laminatschicht auf die TCO-Schicht,
(b2) Auftragen einer Rückelektrodenschicht.

6. Verfahren nach einem der Ansprüche 1 bis 5, wobei die temporäre Substratfolie Aluminium ist.

## Revendications

1. Procédé de fabrication de morceaux d'une feuille ayant un revêtement inorganique, le procédé comprenant les étapes successives de :
(a) fourniture d'une feuille de substrat temporaire gravable,
(b) application du revêtement inorganique sur la feuille de substrat temporaire,
(c) application d'un support permanent,
(d) élimination d'une partie de la feuille de substrat temporaire,
(e) découpe de la feuille le long d'une ligne de découpe en les morceaux, dans lequel la ligne de découpe est positionnée au niveau d'une portion de la feuille où la feuille de substrat temporaire est présente, ladite portion ayant une largeur d'au moins 0,25 mm par rapport à chaque côté de la ligne de découpe,
(f) élimination d'au moins une partie de la feuille de substrat temporaire.

2. Procédé selon la revendication 1, dans lequel entre l'étape (c) et l'étape (e), la feuille de substrat temporaire à la position de la ligne de découpe est éliminée par gravage.

3. Procédé selon la revendication 1 ou 2, dans lequel la feuille de substrat temporaire a une largeur d'au moins 1 mm par rapport à chaque côté de la ligne de découpe.

4. Procédé selon l'une quelconque des revendications 1 à 3, dans lequel la ligne de découpe est positionnée sur une bande de la feuille de substrat temporaire, la bande ayant une largeur inférieure à 20 cm, de préférence inférieure à 10 cm, de manière davantage préférée inférieure à 3 cm.

5. Procédé selon l'une quelconque des revendications 1 à 4, dans lequel la feuille ayant un revêtement inorganique est une pile solaire, un dispositif d'éclairage organique, ou un afficheur, le procédé comprenant les étapes de :
(b) application d'une électrode avant d'un oxyde conducteur transparent (OCT) sur la feuille de substrat temporaire,
(b1) application d'une couche photovoltaïque, d'une couche DELO, ou d'une couche de stratifié de panneau avant sur la couche OCT,
(b2) application d'une couche d'électrode arrière.

6. Procédé selon l'une quelconque des revendications 1 à 5, dans lequel la feuille de substrat temporaire est en aluminium.
